# EUROPEAN PATENT APPLICATION

(11) **EP 4 660 383 A1**
(43) Date of publication of application: **10.12.2025**
(21) Application number: 23930945.3
(22) Date of filing: 21.12.2023
(51) Int. Cl.: E02F 9/20

(54) **CONSTRUCTION EQUIPMENT**

(30) Priority: 31.03.2023 JP 2023059443
(71) Applicant: Hitachi Construction Machinery Tierra Co., Ltd., Shiga 528-0061, (JP)
(72) Inventor: MORI, Kazushige, Koka-shi, Shiga 528-0061 (JP); KAWAGUCHI, Hiroshi, Koka-shi, Shiga 528-0061 (JP); ISHII, Takeshi, Koka-shi, Shiga 528-0061 (JP); TANIGUCHI, Tsukasa, Koka-shi, Shiga 528-0061 (JP); INOUE, Ryoya, Koka-shi, Shiga 528-0061 (JP)
(74) Representative: Manitz Finsterwald Patent- und Rechtsanwaltspartnerschaft mbB
(86) International application number: PCT/JP2023/046030
(87) International publication number: WO 2024/202326

(57) **Abstract**

A construction machine is provided that is capable of charging an electricity storage device with both regenerative electric power from an electrically driven motor and electric power from an external power supply, and restraining the electricity storage device from being deteriorated. An excavator includes an electrically driven motor, an inverter for controlling the electrically driven motor, a controller for controlling the inverter, and an electricity storage device for being charged with electric power from an external power supply. The inverter controls electric power from the external power supply or electric power from the electricity storage device to cause the electrically driven motor to be driven and, upon deceleration of the electrically driven motor, to cause regenerative electric power from the electrically driven motor to be supplied to the electricity storage device to charge the electricity storage device. The controller computes an upper limit value for a regenerative current from the electrically driven motor by subtracting an output current from the external power supply from an upper limit value for a charging current for the electricity storage device, and sends a command representing the upper limit value to the inverter, when the electric power from the external power supply is supplied to the electricity storage device and the electrically driven motor is decelerated.

## Description

### Technical Field

The present invention relates to a construction machine such as an excavator, for example.

### Background Art

Patent Document 1 discloses an excavator as one of construction machines. The excavator disclosed in Patent Document 1 includes an electrically driven motor, a plurality of hydraulic pumps driven by the electrically driven motor, and a plurality of hydraulic actuators driven by a hydraulic fluid delivered from the hydraulic pumps.

The excavator disclosed in Patent Document 1 carries an electricity storage device (e.g., one configured with a lithium ion battery) and can be connected to an external power supply by a power cable. The electrically driven motor can thus be driven by electric power from the electricity storage device. Furthermore, the electricity storage device can be charged with all of the electric power from the electricity storage device or can be charged with excessive part of the electric power supplied from the external power supply while the electrically driven motor is being driven by part of the electric power from the external power supply.

### Prior Art Document

### Patent Document

Patent Document 1: WO2019/208370

### Summary of the Invention

### Problems to be Solved by the Invention

In recent years, for energy saving purposes, there has been proposed a technology for charging an electricity storage device with electric power regenerated by an electrically driven motor when the electrically driven motor is decelerated (including a time of stoppage). If the technology is incorporated in the excavator described above, charging the electricity storage device with only regenerative electric power from the electrically driven motor or with both regenerative electric power from the electrically driven motor and electric power from the external power supply is possible. However, an allowable value (upper limit value) for a charging current for the electricity storage device is determined according to the voltage across the electricity storage device and the temperature of the electricity storage device. If a charging current in excess of the above-described allowable value is generated when the electricity storage device is charged with both regenerative electric power from the electrically driven motor and electric power from the external power supply, then deterioration of the electricity storage device is speeded up.

The present invention has been devised in view of the above problems. It is an object of the present invention to provide a construction machine in which an electricity storage device can be charged with both regenerative electric power from an electrically driven motor and electric power from an external power supply, and that can restrain the electricity storage device from being deteriorated.

### Means for Solving the Problems

In order to achieve the above object, there is provided, according to the present invention, a construction machine including: an electrically driven motor; an inverter for controlling the electrically driven motor; a controller for controlling the inverter; and an electricity storage device for being charged with electric power from an external power supply, the inverter controlling electric power from the external power supply or electric power from the electricity storage device to cause the electrically driven motor to be driven and, upon deceleration of the electrically driven motor, to cause regenerative electric power from the electrically driven motor to be supplied to the electricity storage device to charge the electricity storage device. In the construction machine, the controller is configured to compute a first upper limit value as an upper limit value for a regenerative current from the electrically driven motor by subtracting an output current from the external power supply from an upper limit value for a charging current for the electricity storage device, the upper limit value for the charging current being determined on the basis of a voltage across the electricity storage device and a temperature of the electricity storage device, and sends a command representing the first upper limit value to the inverter, when the electric power from the external power supply is supplied to the electricity storage device and the electrically driven motor is decelerated. Moreover, the inverter limits a reduction rate for a rotational speed of the electrically driven motor such that the regenerative current from the electrically driven motor does not exceed the first upper limit value.

### Advantages of the Invention

According to the present invention, the electricity storage device can be charged with both regenerative electric power from the electrically driven motor and electric power from the external power supply and can be restrained from being deteriorated.

### Brief Description of the Drawings

[Fig. 1] Fig. 1 is a side elevational view illustrating the structure of an excavator according to an embodiment of the present invention.
[Fig. 2] Fig. 2 is a diagram illustrating the configuration of a drive system of the excavator according to the embodiment of the present invention.
[Fig. 3] Fig. 3 is a diagram illustrating the configuration of a control system of the excavator according to the embodiment of the present invention.
[Fig. 4] Fig. 4 is a diagram illustrating the functional configuration of a controller according to the embodiment of the present invention, together with related equipment.
[Fig. 5] Fig. 5 is a flowchart illustrating a processing sequence of the controller according to the embodiment of the present invention.
[Fig. 6] Fig. 6 is a timing chart illustrating changes in the rotational speeds of electrically driven motors and changes in currents according to the embodiment of the present invention and a comparative example.

### Modes for Carrying Out the Invention

An embodiment of the present invention will be described below with reference to the drawings.

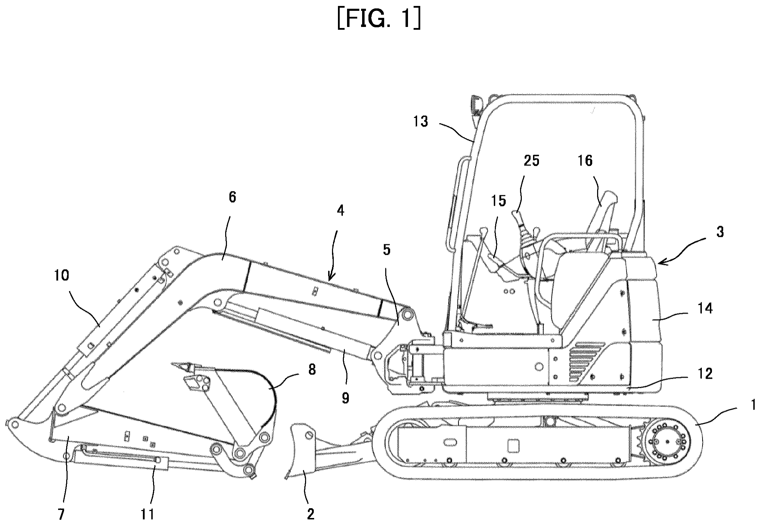

Fig. 1 is a side elevational view illustrating the structure of an excavator according to the present embodiment.

The excavator according to the present embodiment includes a track structure 1, a blade 2 that is mounted movably in upward and downward directions on a front side (left side in Fig. 1) of the track structure 1, a swing structure 3 that is mounted swingably in leftward and rightward directions on an upper side of the track structure 1, and a work implement 4 coupled to a front side (left side in Fig. 1) of the swing structure 3. The track structure 1 travels upon rotation of left and right track motors (not depicted). The blade 2 is moved by a blade cylinder (not depicted) as it is extended and contracted. The swing structure 3 is swung by a swing motor (not depicted) as it rotates.

The work implement 4 includes a post 5 coupled pivotally in leftward and rightward directions to the front side of the swing structure 3, a boom 6 coupled pivotally in upward and downward directions to the post 5, an arm 7 coupled pivotally in upward and downward directions to a distal end of the boom 6, and a bucket 8 coupled pivotally in upward and downward directions to a distal end of the arm 7. The post 5 is pivoted by a post cylinder (not depicted) as it is extended and contracted. The boom 6 is pivoted by a boom cylinder 9 as it is extended and contracted. The arm 7 is pivoted by an arm cylinder 10 as it is extended and contracted. The bucket 8 is pivoted by a bucket cylinder 11 as it is extended and contracted.

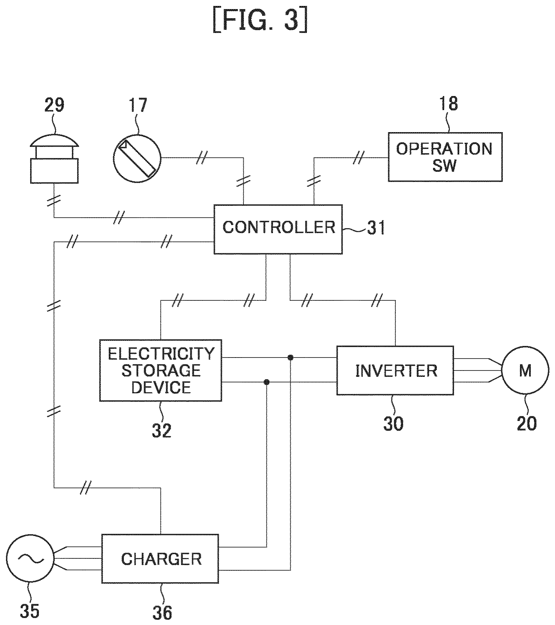

The swing structure 3 includes a swing frame 12 as a basic structure body, a canopy-type cabin 13 mounted on an upper side of the swing frame 12, and a counterweight 14 disposed on a rear side (right side in Fig. 1) of the swing frame 12. A lock lever 15 that the operator can operate selectively into a raised position (a position for allowing the operator to get on and off) and a lowered position (a position for preventing the operator from getting on and off) is disposed in a doorway of the cabin 13. The cabin 13 houses therein an operator's seat 16 on which the operator can be seated, a plurality of operation devices (to be described in detail later) that can be operated by the operator, a rotational speed setting device 17 (see Fig. 3 to be described later), and an operation switch 18 (see Fig. 3 to be described later).

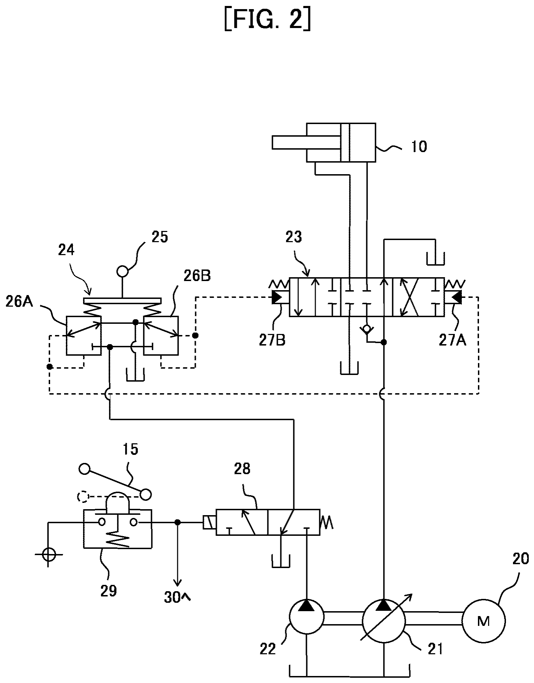

The excavator according to the present embodiment includes a drive system for driving a plurality of hydraulic actuators (specifically, the left and right track motors, the blade cylinder, the swing motor, the post cylinder, the boom cylinder 9, the arm cylinder 10, and the bucket cylinder 11 that have been described above) according to operation on the operation devices. Fig. 2 is a diagram illustrating the configuration relating to the arm cylinder 10 in the configuration of the drive system of the excavator according to the present embodiment.

The drive system according to the present embodiment includes an electrically driven motor 20, a hydraulic pump 21 and a pilot pump 22 that are driven by the electrically driven motor 20, a control valve 23 for controlling the flow (specifically, direction and flow rate) of a hydraulic fluid from the hydraulic pump 21 to the arm cylinder 10, and an operation device 24 for operating the control valve 23.

The operation device 24 includes an operation lever 25 that can be operated by the operator, a pilot valve 26A for reducing the delivered pressure from the pilot valve 22 to generate a pilot pressure on the basis of an operation amount toward one side of the operation lever 25, and a pilot valve 26B for reducing the delivered pressure from the pilot pump 22 to generate a pilot pressure on the basis of an operation amount toward the other side of the operation lever 25.

When the operator operates the operation lever 25 toward the one side thereof, the pilot pressure generated by the pilot valve 26A on the basis of the operation amount is output to a pressure receiving portion 27A of the control valve 23, and the control valve 23 is shifted to a shifted position which is a right side in the figure. Thus, the hydraulic fluid delivered from the hydraulic pump 21 is supplied to a rod side of the arm cylinder 10, and the arm cylinder 10 is driven (contracted).

When the operator operates the operation lever 25 toward the other side thereof, the pilot pressure generated by the pilot valve 26B on the basis of the operation amount is output to a pressure receiving portion 27B of the control valve 23, and the control valve 23 is shifted to a shifted position which is a left side in the figure. Thus, the hydraulic fluid delivered from the hydraulic pump 21 is supplied to a bottom side of the arm cylinder 10, and the arm cylinder 10 is driven (extended).

The configuration relating to the other hydraulic actuators (i.e., the track motors, the post cylinder, the swing motor, the boom cylinder 9, and the bucket cylinder 11) is essentially the same as the configuration relating to the arm cylinder 10. Specifically, a control valve is shifted by a pilot pressure from a corresponding operation device, and a hydraulic fluid delivered from the hydraulic pump is supplied to a hydraulic actuator to drive the hydraulic actuator.

The drive system according to the present embodiment includes a lock valve 28 provided between all the operation devices and the pilot pump 22 as a lock device that is shifted to a locked state that prevents the hydraulic actuators from being driven and to an unlocked state that allows the hydraulic actuators to be driven.

The lock valve 28 is shifted in response to operation on the lock lever 15 described above. Specifically, a lock switch 29 is provided on the lock lever 15. When the lock lever 15 is operated to a locked position (raised position), the lock switch 29 is opened. Thus, since a solenoid portion of the lock valve 28 is not energized, the lock valve 28 is in an interrupting position which is the right side in Fig. 2, preventing the delivered pressure of the pilot pump 22 from being introduced into all the operation devices. Therefore, all the operation devices are unable to generate a pilot pressure, preventing all the hydraulic actuators from being driven (locked state).

On the other hand, when the lock lever 15 is operated to an unlocked position (lowered position), the lock switch 29 is in a closed state. Thus, the solenoid portion of the lock valve 28 is energized, and the lock valve 28 is shifted to a communicating position which is the left side in Fig. 2, so that the delivered pressure of the pilot pump 22 is introduced into all the operation devices. Therefore, all the operation devices are able to generate a pilot pressure, allowing all the hydraulic actuators to be driven (unlocked state). Note that, the lock switch 29 is equivalent to a sensor for sensing whether the lock device is shifted to the locked state or to the unlocked state.

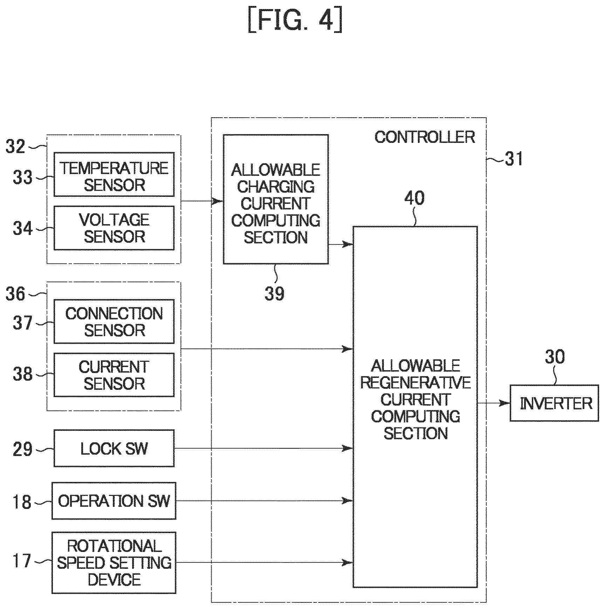

The excavator according to the present embodiment includes a control system that can perform a drive control and regenerative control on the electrically driven motor 20. Fig. 3 is a diagram illustrating the configuration of the control system of the excavator according to the present embodiment. Fig. 4 is a block diagram illustrating the functional configuration of a controller according to the present embodiment, together with related equipment.

The control system according to the present embodiment includes an inverter 30 for controlling the electrically driven motor 20, a controller 31 for controlling the inverter 30, and an electricity storage device 32 connected to the inverter 30. The electricity storage device 32 is configured with a lithium ion battery, for example, and includes a voltage sensor 33 for sensing the voltage across the electricity storage device 32 and a temperature sensor 34 for sensing the temperature of the electricity storage device 32.

The controller 31 has a processor for executing processing in accordance with programs and a memory for storing the programs and data. The controller 31 has a function for controlling the inverter 30 on the basis of input signals supplied thereto from the rotational speed setting device 17, the operation switch 18, and the lock switch 29.

The rotational speed setting device 17 has, for example, a dial that can be operated by the operator and a potentiometer for outputting a signal commensurate with a position to which the dial has been operated by the operator, in order to set a reference rotational speed for the electrically driven motor 20 within a predetermined range (e.g., 2400 to 1200 rpm). The operation switch 18 outputs a signal instructing the electrically driven motor 20 to activate or stop in response to operation thereon by the operator.

When the controller 31 is supplied, from the operation switch 18, with an input signal instructing the electrically driven motor 20 to activate, the controller 31 outputs a command, to the inverter, to cause the electrically driven motor 20 to activate and to increase the rotational speed of the electrically driven motor 20 up to the reference rotational speed set by the rotational speed setting device 17. Thereafter, when the rotational speed setting device 17 changes the reference rotational speed, the controller 31 outputs a command, to the inverter 30, to change the rotational speed of the electrically driven motor 20 so as to be the reference rotational speed which has been changed by the rotational speed setting device 17. Moreover, when the controller 31 determines that the lock valve 28 has been shifted from the communicating position to the interrupting position on the basis of whether it has received signal from the lock switch 29 or not, or when the controller 31 is supplied with a signal instructing the electrically driven motor 20 to stop from the operation switch 18, the controller 31 outputs a command to the inverter 30 to stop the electrically driven motor 20.

The control system according to the present embodiment is configured such that an external power supply 35 (e.g., a commercial power supply) is connectable thereto via a power cable, and the control system includes a charger 36 for supplying electric power from the external power supply 35 to the inverter 30 and the electricity storage device 32. The charger 36 has a function to convert AC electric power from the external power supply 35 into DC electric power and to control an output current, in accordance with a command from the controller 31. Moreover, the charger 36 includes a connection sensor 37 for sensing whether the external power supply 35 is connected or not thereto on the basis of a voltage input to the charger 36 and a current sensor 38 for sensing an output current from the charger 36 (stated otherwise, an output current from the external power supply 35).

The controller 31 is supplied with inputs representing the state information on the electricity storage device 32 (specifically, the voltage sensed by the voltage sensor 33 and the temperature sensed by the temperature sensor 34, for example) and the state information on the charger 36 (specifically whether the external power supply 35 is connected or not thereto, which is sensed by the connection sensor 37, and the output current sensed by the current sensor 38, for example). Then, when the controller 31 is supplied with signals from the operation switch 18, which signals instruct the electrically driven motor 20 to activate and instruct the electricity storage device 32 to start charging, while the external power supply 35 is being connected to the charger 36, the controller 31 outputs a command to the charger 36 to cause electric power supplied from the external power supply 35 to be supplied to the inverter 30 and the electricity storage device 32. Thereafter, when the controller 31 is supplied with signals from the operation switch 18, which signals instruct the electrically driven motor 20 to stop and instruct the electricity storage device 32 to finish charging, the controller 31 outputs a command to the charger 36 to stop supplying electric power to the inverter 30 and the electricity storage device 32.

When the inverter 30 is not supplied with electric power from the external power supply 35, the inverter 30 controls electric power from the electricity storage device 32 to cause the electrically driven motor 20 to be driven, and upon deceleration (including a time of stoppage) of the electrically driven motor 20, to cause regenerative electric power from the electrically driven motor 20 to be supplied to the electricity storage device 32 to charge the electricity storage device 32. On the other hand, when the inverter 30 is supplied with electric power from the external power supply 35, the inverter 30 controls electric power from the external power supply 35 to drive the electrically driven motor 20, and upon deceleration of the electrically driven motor 20, to cause regenerative electric power from the electrically driven motor 20 to be supplied to the electricity storage device 32 to charge the electricity storage device 32. When the inverter 30 causes the electrically driven motor 20 to be driven with part of the electric power from the external power supply 35, the inverter 30 causes the electricity storage device 32 to be charged with excessive part of electric power from the external power supply 35. When regenerative electric power is produced by the electrically driven motor 20 upon deceleration thereof, the electricity storage device 32 is charged with both the regenerative electric power from the electrically driven motor 20 and the electric power from the external power supply 35.

According to features of the present embodiment, the controller 31 has a function to compute an upper limit value for a regenerative current from the electrically driven motor 20 depending on whether or not to charge the electricity storage device 32 with both the regenerative electric power from the electrically driven motor 20 and the electric power from the external power supply 35, and to send a command representing the upper limit value to the inverter 30. The controller 31 has, as functional configurations, an allowable charging current computing section 39 that computes an upper limit value for a charging current for the electricity storage device 32 on the basis of the state information on the electricity storage device 32, and an allowable regenerative current computing section 40 that computes an upper limit value for a regenerative current from the electrically driven motor 20 on the basis of the state information on the charger 36 and the computed result from the allowable charging current computing section 39 and sends a command representing the upper limit value to the inverter 30.

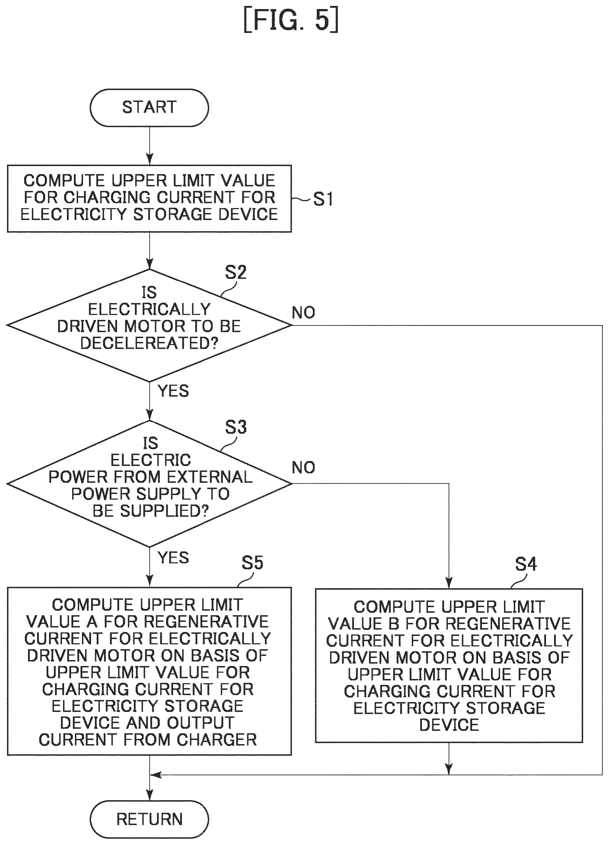

Next, a processing sequence of the controller 31 according to the present embodiment will be described below with reference to Fig. 5. Fig. 5 is a flowchart illustrating the processing sequence of the controller 31 according to the present embodiment. The processing sequence illustrated in Fig. 5 is executed per predetermined period of time.

In step S1, the allowable charging current computing section 39 of the controller 31 computes an upper limit value for a charging current for the electricity storage device 32 on the basis of the voltage across the electricity storage device 32 sensed by the voltage sensor 33 and the temperature of the electricity storage device 32 sensed by the temperature sensor 34. The upper limit value for the charging current is determined based on the voltage and the temperature of the electricity storage device 32, and computed using a table stored in the controller 31, for example.

Thereafter, the processing sequence goes to step S2 in which the allowable regenerative current computing section 40 of the controller 31 determines whether the electrically driven motor 20 is to be decelerated or not on the basis of signals from the lock switch 29, the operation switch 18, and the rotational speed setting device 17, for example. If the allowable regenerative current computing section 40 determines that the electrically driven motor 20 is to be decelerated, then the processing sequence goes to step S3.

In step S3, the allowable regenerative current computing section 40 determines whether electric power from the external power supply 35 is to be supplied to the electricity storage device 32 or not on the basis of the sensing result from the connection sensor 37 and the signal from the operation switch 18.

If the allowable regenerative current computing section 40 determines in step S3 that electric power from the external power supply 35 is not to be supplied to the electricity storage device 32 (i.e., the electricity storage device 32 is to be charged with only the regenerative electric power from the electrically driven motor 20), then the processing sequence goes to step S4. In step S4, the allowable regenerative current computing section 40 computes an upper limit value B (second upper limit value) for a regenerative current from the electrically driven motor 20 so as to be equal to the upper limit value for the charging current for the electricity storage device 32 that has been computed by the allowable charging current computing section 39, and sends a command representing the upper limit value B to the inverter 30. In response to the command described above, the inverter 30 limits a reduction rate for the rotational speed of the electrically driven motor 20 such that the regenerative current from the electrically driven motor 20 does not exceed the upper limit value B.

If the allowable regenerative current computing section 40 determines in step S3 that electric power from the external power supply 35 is to be supplied to the electricity storage device 32 (i.e., the electricity storage device 32 is to be charged with the regenerative electric power from the electrically driven motor 20 and the electric power from the external power supply 35), then the processing sequence goes to step S5. In step S5, the allowable regenerative current computing section 40 computes an upper limit value A (first upper limit value) for a regenerative current from the electrically driven motor 20 by subtracting the output current from the charger 36 that has been sensed by the current sensor 38 from the upper limit value for the charging current for the electricity storage device 32 that has been computed by the allowable charging current computing section 39, and sends a command representing the upper limit value A to the inverter 30. In response to the command, the inverter 30 limits a reduction rate for the rotational speed of the electrically driven motor 20 such that the regenerative current from the electrically driven motor 20 does not exceed the upper limit value A.

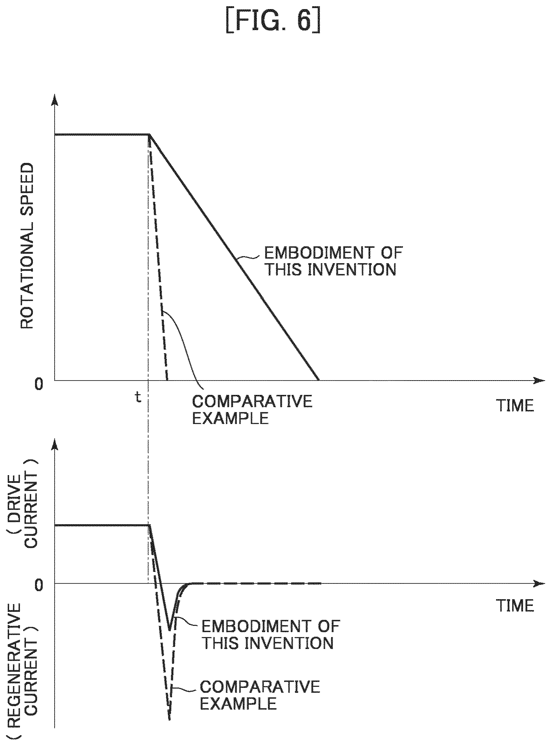

Next, effects and advantages of the present embodiment will be described below with reference to Fig. 6. Fig. 6 is a timing chart illustrating changes in the rotational speeds and currents of electrically driven motors according to the present embodiment and a comparative example. In Fig. 6, a positive current represents a drive current from the inverter 30 to the electrically driven motor 20 whereas a negative current represents a regenerative current from the electrically driven motor 20 to the inverter 30.

For charging the electricity storage device 32 with both the regenerative electric power from the electrically driven motor 20 and the electric power from the external power supply 35, a controller according to the comparative example computes an upper limit value for the regenerative current from the electrically driven motor 20 so as to be equal to the upper limit value for the charging current for the electricity storage device 32, and sends a command representing the upper limit value to the inverter 30. Therefore, as depicted by the dotted-line curves in Fig. 6, when the lock device is shifted from the unlocked state to the locked state to stop the electrically driven motor 20 (time t), the rotational speed of the electrically driven motor 20 decreases rapidly, resulting in an instantaneous and sharp increase in the regenerative current from the electrically driven motor 20. Thus, the charging current for the electricity storage device 32 exceeds its allowable value, speeding up deterioration of the electricity storage device 32.

On the other hand, for charging the electricity storage device 32 with both the regenerative electric power from the electrically driven motor 20 and the electric power from the external power supply 35, the controller 31 according to the present embodiment computes an upper limit value A for a regenerative current from the electrically driven motor 20 by subtracting the output current from the charger 36 from the upper limit value for the charging current for the electricity storage device 32, and sends a command representing the upper limit value A to the inverter 30. Therefore, as indicated by the solid-line curves in Fig. 6, when the lock device is shifted from the unlocked state to the locked state to stop the electrically driven motor 20 (time t), the rotational speed of the electrically driven motor 20 decreases gradually, and following this, the regenerative current from the electrically driven motor 20 increases not significantly but instantaneously. Thus, the charging current for the electricity storage device 32 does not exceed its allowable value, preventing the electricity storage device 32 from being deteriorated.

According to the present embodiment, therefore, the electricity storage device 32 is charged with both the regenerative electric power from the electrically driven motor 20 and the electric power from the external power supply 35, and is prevented from being deteriorated.

According to the present embodiment, the charger 36 is provided in the excavator by way of example. However, the present invention is not limited to such a case. The charger 36 may alternatively be provided in the external power supply 35.

According to the present embodiment, it has been described an example that the controller 31 computes an upper limit value for a regenerative current from the electrically driven motor 20 by subtracting the output current from the charger 36 (stated otherwise, the output current from the external power supply 35) from the upper limit value for the charging current for the electricity storage device 32 when electric power from the external power supply 35 is supplied to the electricity storage device 32 and the electrically driven motor 20 is decelerated. However, the present invention is not limited to such a case. The controller 31 may alternatively compute an upper limit value for a regenerative current from the electrically driven motor 20 by subtracting the output current from the charger 36 (stated otherwise, the output current from the external power supply 35) and a predetermined marginal value from the upper limit value for the charging current for the electricity storage device 32, when electric power from the external power supply 35 is supplied to the electricity storage device 32 and the electrically driven motor 20 is decelerated.

According to the present embodiment, it has been described an example that the controller 31 computes an upper limit value for a regenerative current from the electrically driven motor 20 so as to be equal to the upper limit value for the charging current for the electricity storage device 32, when electric power from the external power supply 35 is not supplied to the electricity storage device 32 and the electrically driven motor 20 is decelerated. However, the present invention is not limited to such a case. The controller 31 may alternatively compute an upper limit value for a regenerative current from the electrically driven motor 20 by subtracting a predetermined marginal value from the upper limit value for the charging current for the electricity storage device 32, when electric power from the external power supply 35 is not supplied to the electricity storage device 32 and the electrically driven motor 20 is decelerated.

It has been described an example that the present invention is applied to an excavator. However, the present invention is not limited to such a case, but may be applied to other construction machines.

### Description of Reference Characters

20: electrically driven motor
30: inverter
31: controller
32: electricity storage device
33: voltage sensor
34: temperature sensor
35: external power supply
38: current sensor

## Claims

1. A construction machine comprising:
an electrically driven motor;
an inverter for controlling the electrically driven motor;
a controller for controlling the inverter; and
an electricity storage device for being charged with electric power from an external power supply,
the inverter controlling electric power from the external power supply or electric power from the electricity storage device to cause the electrically driven motor to be driven and, upon deceleration of the electrically driven motor, to cause regenerative electric power from the electrically driven motor to be supplied to the electricity storage device to charge the electricity storage device, wherein
the controller is configured to compute a first upper limit value as an upper limit value for a regenerative current from the electrically driven motor by subtracting an output current from the external power supply from an upper limit value for a charging current for the electricity storage device, the upper limit value for the charging current being determined on a basis of a voltage across the electricity storage device and a temperature of the electricity storage device, and sends a command representing the first upper limit value to the inverter, when the electric power from the external power supply is supplied to the electricity storage device and the electrically driven motor is decelerated, and
the inverter limits a reduction rate for a rotational speed of the electrically driven motor such that the regenerative current from the electrically driven motor does not exceed the first upper limit value.

2. The construction machine according to claim 1,
wherein
the controller is configured to compute a second upper limit value as an upper limit value for a regenerative current from the electrically driven motor so as to be equal to the upper limit value for the charging current for the electricity storage device and sends a command representing the second upper limit value to the inverter, when the electric power from the external power supply is not supplied to the electricity storage device and the electrically driven motor is decelerated, and
the inverter limits the reduction rate for the rotational speed of the electrically driven motor such that the regenerative current from the electrically driven motor does not exceed the second upper limit value.

3. The construction machine according to claim 1,
wherein
the construction machine includes
a voltage sensor for sensing a voltage across the electricity storage device, and
a temperature sensor for sensing a temperature of the electricity storage device, and
the controller is configured to
compute the upper limit value for the charging current for the electricity storage device on the basis of the voltage across the electricity storage device sensed by the voltage sensor and the temperature of the electricity storage device sensed by the temperature sensor.
